# EUROPÄISCHE PATENTSCHRIFT

(11) **EP 3 298 478 B1**
(45) Veröffentlichungstag und Bekanntmachung des Hinweises auf die Patenterteilung: **10.07.2019**
(21) Anmeldenummer: 16727966.0
(22) Anmeldetag: 19.05.2016
(51) Int. Cl.: B60K 37/06, H03K 17/00, G06F 3/041, G06F 3/01, G06F 3/0354

(54) **BEDIENVORRICHTUNG UND VERFAHREN ZUM ANSTEUERN VON FUNKTIONSEINHEITEN EINES KRAFTFAHRZEUGS UND KRAFTFAHRZEUG**
OPERATING DEVICE AND METHOD FOR CONTROLLING FUNCTIONAL UNITS OF A MOTOR VEHICLE AND MOTOR VEHICLE
DISPOSITIF DE COMMANDE ET PROCÉDÉ POUR ACTIONNER DES UNITÉS FONCTIONNELLES D'UN VÉHICULE AUTOMOBILE ET VÉHICULE AUTOMOBILE

(30) Priorität: 21.05.2015 DE 102015006605
(43) Veröffentlichungstag der Anmeldung: 28.03.2018
(73) Patentinhaber: Audi AG, 85045 Ingolstadt (DE)
(72) Erfinder: MÜLLER, Ulrich, 85055 Ingolstadt (DE); KÜHNER, Manuel, 71706 Markgröningen (DE)
(86) Internationale Anmeldenummer: PCT/EP2016/061282
(87) Internationale Veröffentlichungsnummer: WO 2016/184968

(56) Entgegenhaltungen:
- EP-A1- 2 515 209
- US-A1- 2014 267 065
- US-B1- 6 219 034

## Beschreibung

Die Erfindung betrifft eine Bedienvorrichtung zum Ansteuern von Funktionseinheiten. Die Bedienvorrichtung weist eine berührungsempfindliche Oberfläche auf und Mittel zum Erfassen einer Kraft, welche von einem Benutzer auf wenigstens einen Bereich der berührungsempfindlichen Oberfläche aufgebracht wird. Ein Aktor der Bedienvorrichtung dient dem Erzeugen einer haptischen Rückmeldung an den Benutzer in Abhängigkeit vom Überschreiten eines Schwellenwerts der Kraft. Des Weiteren betrifft die Erfindung ein Kraftfahrzeug und ein Verfahren zum Ansteuern von Funktionseinheiten eines Kraftfahrzeugs.

Bei Kraftfahrzeugen finden zunehmend Toucheingabegeräte Verwendung, bei welchen ein haptisches Feedback realisiert ist. Hierbei handelt es sich um eine künstlich erzeugte, also aktorische, aktive haptische Rückmeldung. So wird einem Benutzer, welcher das Toucheingabegerät bedient, deutlich gemacht, dass eine Bedienhandlung als solche erkannt wurde, indem der Aktor eine haptisch erfassbare Bewegung der berührten Oberfläche bewirkt. Des Weiteren weisen derartige Toucheingabegeräte teilweise Mittel zur Krafterkennung auf. Es wird also das Auslösen von Funktionen nicht nur von der Berührung des Toucheingabegeräts abhängig gemacht. Vielmehr hängt das Auslösen einer gewünschten Funktion auch von der vom Benutzer aufgebrachten Kraft ab, so wie ein Benutzer dies von einer mechanischen Taste gewohnt ist. Beispielsweise weist die aktuelle C-Klasse des Automobilherstellers Mercedes-Benz ein Touchpad auf, bei welchem eine Krafterkennung realisiert ist und ein haptisches Feedback künstlich erzeugt wird.

Die EP 2 515 209 A1 beschreibt eine taktile Anzeigeeinrichtung, bei welcher ein Berührungssensor auf einer Anzeigeeinheit angeordnet ist. Eine Lasterkennungseinheit erfasst eine Druckbeanspruchung, welche vom Druck eines Fingers einer Bedienperson auf der Anzeigeeinheit herrührt. Eine Steuereinheit kann eine Standardbelastung anpassen, bei welcher die Bedienperson eine taktile Rückmeldung spürt. Hierbei wird für eine Bedienperson, welche mit einer rasch ansteigenden Kraft auf die Anzeigeeinheit drückt, eine größere Standardbelastung eingestellt, als für eine Bedienperson, welche eine sich langsam ändernde Kraft auf die Anzeigeeinheit ausübt.

Des Weiteren beschreibt die DE 10 2008 036 155 A1 eine Bedientastenanordnung für ein Kraftfahrzeug mit einer Bedientaste. Die Bedientaste weist eine Oberfläche auf und einen Drucksensor. Ein Aktuator dient dem Erzeugen einer haptischen Reaktion bei Betätigung der Bedientaste. Das Erzeugen der haptischen Reaktion mittels des Aktuators ist hierbei davon abhängig, ob eine Bedienkraft einen Schwellenwert erreicht.

Die DE 11 2013 002 410 T5 beschreibt eine haptische Vorrichtung wie einen Tablet-Computer oder ein Smartphone. Auch hier kann eine haptische Rückmeldung an einen Benutzer durch ein Bewegen, Vibrieren oder Schwanken einer Oberfläche erfolgen. Eine Rückmeldungskraft kann hierbei mit einer Rate korreliert werden, mit welcher vom Benutzer eine Druckkraft auf die Oberfläche der haptischen Vorrichtung aufgebracht wird.

Die DE 11 2013 002 409 T5 beschreibt eine elektronische Vorrichtung mit einer berührungsempfindlichen Oberfläche für die Anzeige zusätzlicher Informationen als Reaktion auf einen Benutzerkontakt. Bei einem Kontakt mit einer bestimmten Intensität wird die zusätzliche Information angezeigt, ohne dass eine vordefinierte Verzögerungszeit abgewartet wird. Bei einem Kontakt mit einer Intensität unterhalb einer bestimmten Intensitätsschwelle wird jedoch zunächst die vordefinierte Verzögerungszeit abgewartet, bevor die zusätzliche Information angezeigt wird. Die Vorrichtung kann taktile Ausgabegeneratoren aufweisen, welche mit einer haptischen Rückmeldesteuereinheit gekoppelt sind.

Bei aus dem Stand der Technik bekannten Bedienvorrichtungen zum Ansteuern von Funktionseinheiten eines Kraftfahrzeugs wird das haptische Feedback beim Überschreiten eines Schwellenwerts der vom Benutzer aufgebrachten Kraft ausgelöst. Um die Kosten in einem vertretbaren Rahmen zu halten und auch aufgrund technischer Randbedingungen gibt es hierbei jedoch immer einen gewissen zeitlichen Verzug zwischen dem Überschreiten des Schwellenwerts der Kraft und dem tatsächlichen Auslösen der haptischen Rückmeldung. Dies hat zur Folge, dass die tatsächliche haptische Rückmeldung zeitlich später ausgelöst wird und somit erst bei einer höheren Kraft als der Kraftschwelle. Aus Sicht des Benutzers wirkt dies wie eine erhöhte Auslösekraft, welche aufgebracht werden muss, um die haptische Rückmeldung zu erhalten. Zudem hängt diese höhere Auslösekraft noch von der Betätigungsgeschwindigkeit ab oder, genauer gesagt, vom zeitlichen Verlauf des Anstiegs der Kraft.

Dies bringt bedeutende Nachteile mit sich. Zum einen kann sich die wahrgenommene oder wirksame Auslösekraft beträchtlich von dem gewünschten Schwellenwert der Kraft unterscheiden. Des Weiteren ist die wahrgenommene oder wirksame Auslösekraft nicht konstant, sondern variabel, und sie ist abhängig von der Art der Betätigung, also der Betätigungscharakteristik.

Aufgabe der vorliegenden Erfindung ist es daher, eine verbesserte Bedienvorrichtung der eingangs genannten Art, ein Kraftfahrzeug mit einer solchen Bedienvorrichtung sowie ein verbessertes Verfahren zum Ansteuern von Funktionseinheiten eines Kraftfahrzeugs zu schaffen.

Diese Aufgabe wird durch eine Bedienvorrichtung mit den Merkmalen des Patentanspruchs 1, ein Kraftfahrzeug mit den Merkmalen des Patentanspruchs 6 und durch ein Verfahren mit den Merkmalen des Patentanspruchs 7 gelöst. Vorteilhafte Ausgestaltungen mit zweckmäßigen Weiterbildungen der Erfindung sind in den abhängigen Patentansprüchen angegeben.

Bei der erfindungsgemäßen Bedienvorrichtung ist eine Auswerteeinrichtung der Bedienvorrichtung dazu ausgebildet, einen auf die Zeit bezogenen Gradienten der Kraft zu ermitteln, welche der Benutzer auf den wenigstens einen Bereich der berührungsempfindlichen Oberfläche aufbringt. Die Auswerteeinrichtung ist des Weiteren dazu ausgebildet, den Schwellenwert der Kraft in Abhängigkeit von dem ermittelten Gradienten zu verändern. Dem liegt die Erkenntnis zugrunde, dass der Kraftanstieg, also der Gradient der von dem Benutzer aufgebrachten Kraft, zusammen mit der systembedingten Verzögerungszeit einen Einfluss auf die effektive Kraftschwelle hat, bei deren Überschreiten der Aktor die haptische Rückmeldung erzeugt.

Durch das Ermitteln oder Erfassen des Gradienten der Kraft ist es bei der Bedienvorrichtung nun jedoch möglich, den Schwellenwert der Kraft anzupassen oder zu verändern. Dadurch kann erreicht werden, dass nahezu unabhängig von der Geschwindigkeit, mit welcher der Benutzer beim Bedienen der Bedienvorrichtung durch das Berühren des wenigstens einen Bereichs der berührungsempfindlichen Oberfläche die Kraft aufbringt, die gefühlte Auslösekraft stets dieselbe bleibt. Es kann also verhindert werden, dass sich die Bedienung der Bedienvorrichtung zäh oder träge anfühlt.

So kann beispielsweise dafür gesorgt werden, dass sowohl beim raschen Aufbringen eines vergleichsweise großen Drucks auf den wenigstens einen Bereich der berührungsempfindlichen Oberfläche durch den Benutzer einerseits als auch bei einem langsamen Kraftanstieg oder Gradienten der Kraft andererseits die haptische Rückmeldung bei einem jeweils in etwa gleichen Wert der aufgebrachten Kraft wahrgenommen wird. Dies erhöht nicht nur den Bedienkomfort beim Ansteuern der Funktionseinheiten eines Kraftfahrzeugs. Vielmehr ist ein solches zuverlässiges und von der Betätigungscharakteristik her gleichartiges Bedienen der Funktionseinheiten des Kraftfahrzeugs, welches zumindest weniger abhängig von der Betätigungsgeschwindigkeit beziehungsweise vom Kraftgradienten ist, auch der Fahrsicherheit zuträglich. Denn der Fahrer, welcher die Bedienvorrichtung bedient, um eine Funktionseinheit wie etwa eine Klimaanlage, ein Navigationssystem, ein Infotainmentsystem oder dergleichen anzusteuern, ist nicht durch unterschiedlich hohe gefühlte oder wahrgenommene Auslösekräfte der haptischen Rückmeldung, also durch variierende gefühlte Kraftschwellen, verwirrt.

Die Auswerteeinrichtung ist dazu ausgebildet, den Schwellenwert der Kraft in Abhängigkeit von dem ermittelten Gradienten zu verringern. Denn die systembedingte Verzögerungszeit führt üblicherweise dazu, dass die wahrgenommene Auslösekraft, also der Wert der Kraft, bei welchem der Benutzer die haptische Rückmeldung tatsächlich wahrnimmt, hin zu einem größeren Wert verschoben wird, sofern der Schwellenwert der Kraft unverändert bleibt, bei dessen Überschreitung der Aktor zum Erzeugen der haptischen Rückmeldung angesteuert wird.

Daher ist das Verringern des Schwellenwerts der Kraft in Abhängigkeit vom ermittelten Gradienten besonders dazu geeignet, dem Benutzer eine gleichbleibende gefühlte Auslösekraft zu vermitteln.

Des Weiteren ist die Auswerteeinrichtung dazu ausgebildet, den Schwellenwert der Kraft auf etwa 70 % bis 90 % eines Ausgangswerts der Kraft zu verringern, wenn ein Wert des Gradienten größer ist als ein vorbestimmter Wert. Dem liegt die Erkenntnis zugrunde, dass es bei einem sehr langsamen Kraftanstieg, also bei einem besonders kleinen Wert des Gradienten, selbst bei einer gewissen Verzögerungszeit zwischen dem Überschreiten des Schwellenwerts der Kraft und dem tatsächlichen Erzeugen der haptischen Rückmeldung durch den Aktor kaum zu einer Erhöhung der wahrgenommenen Kraftschwelle kommt. Denn innerhalb der Verzögerungszeit erhöht sich bei einem geringen Wert des Gradienten die Kraftschwelle nur unmerklich. Dies ist beispielsweise der Fall, wenn der Gradient der Kraft weniger als 0,5 N pro 10 Millisekunden, insbesondere weniger als 0,2 N pro 10 Millisekunden beträgt.

Ändert sich die Kraft pro Zeiteinheit hingegen sehr schnell, ist also der Wert des Gradienten größer als ein vorbestimmter Wert, so führt dieselbe Verzögerungszeit bereits zu einem merklichen Erhöhen der wahrgenommenen Kraftschwelle, also des Werts der Kraft, bei welchem der Benutzer tatsächlich die haptische Rückmeldung wahrnimmt. Dies kann jedoch durch das Verringern des Schwellenwerts der Kraft auf beispielsweise 80 % des Ausgangswerts der Kraft kompensiert werden.

Beispielsweise kann der Ausgangswert der Kraft bei 5 N liegen. Entsprechend erzeugt der Aktor die haptische Rückmeldung, wenn die vom Benutzer aufgebrachte Kraft 5 N überschreitet. Liegt jedoch die systembedingte Verzögerungszeit im Bereich von beispielsweise 10 Millisekunden und beträgt der Gradient beispielsweise 1 N pro 10 Millisekunden, so würde das Beibehalten des Schwellenwerts der Kraft bei 5 N dazu führen, dass der Benutzer erst beim Erreichen einer Kraft von 6 N die haptische Rückmeldung wahrnimmt. Wird jedoch der Schwellenwert der Kraft auf 80 Prozent des Ausgangswerts von 5 N reduziert, also auf einen Wert von 4 N, so nimmt der Benutzer die haptische Rückmeldung wahr, sobald er tatsächlich die Kraft von 5 N auf die berührungsempfindliche Oberfläche aufbringt.

Als vorteilhaft hat es sich gezeigt, wenn die Auswerteeinrichtung dazu ausgebildet ist, beim Verändern des Schwellenwerts der Kraft die Länge einer Zeitspanne zu berücksichtigen, um welche das Erzeugen der haptischen Rückmeldung gegenüber dem Überschreiten des Schwellenwerts der Kraft verzögert ist. Diese systembedingte Verzögerungszeit ist nämlich von Relevanz dafür, wann der Benutzer die erzeugte haptische Rückmeldung wahrnimmt. Ist daher die Länge dieser Zeitspanne bekannt, so kann diese derart beim Verändern des Schwellenwerts der Kraft berücksichtigt werden, dass die vom Benutzer gefühlte Auslösekraft weitgehend unabhängig vom Gradienten der Kraft ist.

Insbesondere kann die Auswerteeinrichtung dazu ausgebildet sein, den Schwellenwert der Kraft umso stärker zu verändern, insbesondere zu verringern, je größer die Länge der Zeitspanne ist. So kann systembedingt unterschiedlich großen Verzögerungszeiten besonders gut Rechnung getragen werden.

Von Vorteil ist es weiterhin, wenn die Bedienvorrichtung Mittel zum Erfassen der Länge der Zeitspanne aufweist. Dann kann nämlich dem Umstand Rechnung getragen werden, dass diese Verzögerungszeit nicht notwendigerweise konstant ist. Vielmehr kann nämlich die Länge der Zeitspanne über die Lebensdauer der Bedienvorrichtung und/oder in Abhängigkeit von äußeren Einflussfaktoren wie beispielsweise der Temperatur veränderlich sein. Solche Veränderungen können besonders gut berücksichtigt werden, wenn die Bedienvorrichtung die Mittel zum Erfassen der Länge der Zeitspanne aufweist.

Die Bedienvorrichtung kann insbesondere als Touchpad (Tastfeld) oder als Touchscreen (Berührungsbildschirm) ausgebildet sein. Derartige Bedienvorrichtungen sind nämlich in einem Kraftfahrzeug zum Ansteuern der Funktionseinheiten besonders günstig.

Bei der Bedienvorrichtung kann es sich jedoch auch um eine Bedientaste handeln (oder sie kann wenigstens eine Bedientaste umfassen), bei welcher der Aktor für das Erzeugen der haptischen Rückmeldung sorgt.

Das erfindungsgemäße Kraftfahrzeug umfasst wenigstens eine erfindungsgemäße Bedienvorrichtung.

Bei dem erfindungsgemäßen Verfahren zum Ansteuern von Funktionseinheiten eines Kraftfahrzeugs wird eine Kraft erfasst, welche von einem Benutzer auf wenigstens einen Bereich einer berührungsempfindlichen Oberfläche einer Bedienvorrichtung aufgebracht wird. Mittels eines Aktors wird in Abhängigkeit vom Überschreiten eines Schwellenwerts der Kraft eine haptische Rückmeldung an den Benutzer erzeugt. Des weiteren wird in Abhängigkeit von dem Überschreiten des Schwellenwerts der Kraft die wenigstens eine Funktionseinheit angesteuert. Hierbei wird mittels einer Auswerteeinrichtung der Bedienvorrichtung ein auf die Zeit bezogener Gradient der Kraft ermittelt.

Der Schwellenwert der Kraft wird in Abhängigkeit von dem ermittelten Gradienten verändert.

Die für die erfindungsgemäße Bedienvorrichtung beschriebenen Vorteile und bevorzugten Ausführungsformen gelten auch für das erfindungsgemäße Kraftfahrzeug und für das erfindungsgemäße Verfahren.

Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen als von der Erfindung umfasst und offenbart anzusehen, die in den Figuren nicht explizit gezeigt oder erläutert sind, jedoch durch separierte Merkmalskombinationen aus den erläuterten Ausführungen hervorgehen und erzeugbar sind.

Weitere Vorteile, Merkmale und Einzelheiten der Erfindung ergeben sich aus den Ansprüchen, der nachfolgenden Beschreibung bevorzugter Ausführungsformen sowie anhand der Zeichnungen. Dabei zeigen:
- Fig. 1: stark schematisiert eine Bedienvorrichtung eines Kraftfahrzeugs, bei welcher ein Aktor eine haptische Rückmeldung erzeugt, wenn eine von einem Benutzer aufgebrachte Kraft einen Schwellenwert überschreitet;
- Fig. 2: in einem Graphen den Verlauf der Kraft über die Zeit und den Schwellenwert der Kraft, bei dessen Überschreiten der Aktor angesteuert wird;
- Fig. 3: einen exemplarischen Kraft-Zeit-Verlauf beim Betätigen eines aktorischen Eingabegeräts, bei welchem ein haptisches Feedback ausgelöst wird; und
- Fig. 4: schematisch zwei unterschiedliche Kraftanstiege beim Bedienen der in Fig. 1 gezeigten Bedienvorrichtung, welche bei gleichem zeitlichen Verzug unterschiedliche effektive Kraftschwellen zur Folge haben.

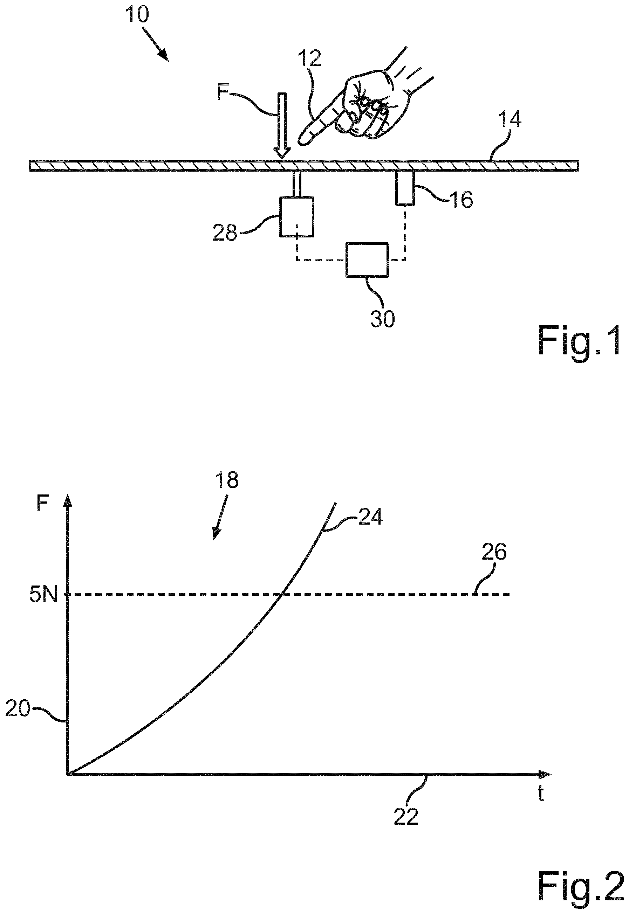

Fig. 1 zeigt schematisch eine Bedienvorrichtung 10, welche beispielsweise als Touchpad oder Touchscreen ausgebildet ist und dem Ansteuern von Funktionseinheiten eines Kraftfahrzeugs dient. Wenn ein Benutzer beispielsweise mit einem Finger 12 eine Kraft F auf eine berührungsempfindliche Oberfläche 14 der Bedienvorrichtung 10 aufbringt, so wird die Kraft F insbesondere mittels eines Sensors 16 oder mehrerer Sensoren 16 erfasst. Die beispielsweise kapazitiven, optischen, induktiven oder als Dehnungsmessstreifen ausgebildeten Sensoren 16 erfassen hierbei in der Regel eine Wegänderung beziehungsweise eine Verformung einer elastischen Komponente und messen die Kraft F daher nur indirekt. Anstelle des Sensors 16 oder zusätzlich zu diesem können auch andere Mittel zum Erfassen der Kraft F vorgesehen sein.

In einem in Fig. 2 gezeigten Graphen 18 ist die Kraft F auf einer Ordinate 20 aufgetragen und die Zeit t auf einer Abszisse 22. Eine Kurve 24 veranschaulicht den Verlauf der Kraft F über die Zeit t. Des Weiteren ist in dem Graphen 18 ein Schwellenwert 26 der Kraft F angegeben. Beim Überschreiten dieses Schwellenwerts 26 wird ein Aktor 28 angesteuert (vergleiche Fig. 1), welcher eine haptische Rückmeldung erzeugt.

Beispielsweise kann der Aktor 28 ein Vibrieren der berührungsempfindlichen Oberfläche 14 oder eine laterale Bewegung derselben bewirken. Dies gibt einerseits dem Benutzer zu verstehen, dass das Aufbringen der Kraft F als von dem Benutzer gewünschte Bedienhandlung, also als Betätigung der Bedienvorrichtung 10, interpretiert wurde. Zudem wird daraufhin die vom Benutzer gewünschte Funktionseinheit angesteuert, etwa indem eine Funktion einer Klimaanlage des Kraftfahrzeugs eingeschaltet wird, oder ein Navigationssystem, ein Infotainmentsystem oder dergleichen.

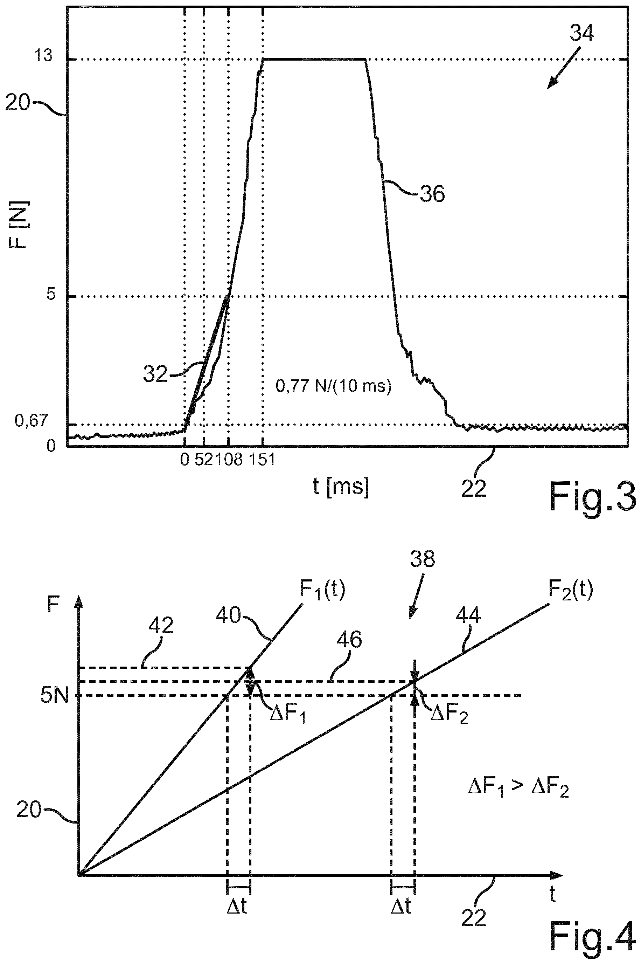

Das Ansteuern des Aktors 28 in Abhängigkeit von der mittels des Sensors 16 erfassten Kraft F erfolgt vorliegend über eine Auswerteeinrichtung 30, welche beispielsweise als Steuergerät ausgebildet sein kann. Vorliegend ist jedoch die Auswerteeinrichtung 30 dazu ausgelegt, den Schwellenwert 26 der Kraft F zu verändern. Hierfür ermittelt die Auswerteeinrichtung 30 einen auf die Zeit t bezogenen Gradienten 32 der vom Benutzer beim Berühren der Bedienvorrichtung 10 aufgebrachten Kraft F, wie mit Bezug auf Fig. 3 und Fig. 4 erläutert werden wird.

Fig. 3 zeigt in einem weiteren Graphen 34 mit der Ordinate 20 und der Abszisse 22 anhand einer Kurve 36 einen exemplarischen Kraft-Zeit-Verlauf beim Betätigen der Bedienvorrichtung 10. Hierbei erfolgt ein haptisches Feedback, also eine haptische Rückmeldung, welche vom Aktor 28 ausgelöst wurde, bei einer Kraft F von 5 N. Realistische Werte für den Schwellenwert 26 können zwischen 1 N und 7 N liegen, wobei insbesondere Werte um 3,5 N vom Bedienkomfort her als angenehm empfunden werden. In einem Zeitfenster von 0 Millisekunden bis 108 Millisekunden beträgt bei der in Fig. 3 gezeigten Kurve 36 der Gradient 32, also der Anstieg der Kraft pro Zeiteinheit, etwa 0,77 N pro 10 Millisekunden.

Üblicherweise gibt es eine gewisse Verzögerungszeit, also einen zeitlichen Verzug zwischen dem Überschreiten des Schwellenwerts 26 der Kraft F und dem Auslösen der haptischen Rückmeldung mittels des Aktors 28. Eine solche Verzögerungszeit, welche auch als Delay oder Latenz bezeichnet werden kann, kann beispielsweise bei 10 Millisekunden bis 20 Millisekunden liegen. Bezogen auf den exemplarischen Gradienten 32 in Fig. 3 führt jedoch eine Verzögerung von 20 Millisekunden zu einem Anstieg der wahrgenommenen Kraftschwelle von etwa 1,5 N. Die haptische Rückmeldung wird also nicht wie gewünscht unmittelbar dann erzeugt, sobald die vom Benutzer aufgebrachte Kraft F den Schwellenwert 26 überschreitet, sondern aufgrund der Verzögerungszeit erst dann, wenn der Benutzer tatsächlich bereits eine Kraft F von etwa 6,5 N aufbringt. Dies ist aus Sicht des Benutzers deutlich zu spüren und führt dazu, dass sich das System, also die Bedienvorrichtung 10, träge oder zäh anfühlt.

Der Einfluss der Verzögerungszeit auf die tatsächlich vom Benutzer wahrgenommene Kraftschwelle, also den Wert der Kraft F, bei welchem die vom Aktor 28 erzeugte haptische Rückmeldung vom Benutzer mit dem Tastsinn erfasst werden kann, soll im Folgenden anhand von Fig. 4 nochmals verdeutlich werden. In einem in Fig. 4 gezeigten weiteren Graphen 38 ist wiederum auf der Ordinate 20 die Kraft F in N und auf der Abszisse 22 die Zeit t aufgetragen. Eine erste Linie 40 veranschaulicht einen vergleichsweise raschen Kraftanstieg F₁(t). Angenommen sei eine bestimmte Verzögerungszeit, also eine Zeitspanne Δt von beispielsweise 10 Millisekunden, um welche das Erzeugen der haptischen Rückmeldung gegenüber dem Überschreiten des Schwellenwerts 26 der Kraft F verzögert ist. Entsprechend der Linie 40 ergibt sich also ein Gradient ΔF₁/Δt, welcher vorliegend einer bestimmten Steigerung der Linie 40 entspricht. Der Gradient der Linie 40 führt also dazu, dass erst beim Erreichen eines Werts der Kraft F, welcher in Fig. 4 durch eine Hilfslinie 42 angegeben ist, der Benutzer die vom Aktor 28 ausgelöste haptische Rückmeldung spürt.

Demgegenüber veranschaulicht eine zweite gerade Linie 44 in dem Graphen 38 in Fig. 4 einen langsameren Kraftanstieg F₂(t). Hier bestimmt sich der Gradient der Kraft F nach ΔF₂/Δt. Dementsprechend wird mit gleicher Zeitverzögerung, also nach einer gleich langen Zeitspanne Δt, um welche das Erzeugen der haptischen Rückmeldung gegenüber dem Überschreiten des Schwellenwerts 26 der Kraft F verzögert ist, die haptische Rückmeldung vom Aktor 28 erzeugt. Die haptische Rückmeldung wird vom Aktor 28 also erzeugt, sobald die Kraft F, welche der Benutzer aufbringt, einen Wert erreicht, welcher in Fig. 4 durch eine weitere Hilfslinie 46 veranschaulicht ist. Es wird also bei geringerem Kraftanstieg und gleicher Verzögerungszeit oder Zeitspanne Δt die haptische Rückmeldung in Bezug auf die vom Benutzer aufgebrachte Kraft F "früher", nämlich bei Vorliegen einer niedrigeren Kraft F, vom Benutzer wahrgenommen.

Vorliegend ist nun die Auswerteeinrichtung 30 dazu ausgebildet, den Gradienten 32 der Kraft F zu ermitteln und den Schwellenwert 26 in Abhängigkeit von dem ermittelten Gradienten zu verringern, also nach unten anzupassen. Ist der Kraftanstieg sehr langsam, ist der Gradient 32 also vergleichsweise gering, dann kann die Kraftschwelle, also der Schwellenwert 26 der Kraft F, nahezu unverändert bleiben, und beispielsweise bei etwa 5 N liegen oder knapp unter 5 N liegen, also knapp unter dem Ausgangswert.

Liegt jedoch ein schneller Kraftanstieg vor, also beispielsweise ein Gradient 32 von 1 N pro 10 Millisekunden, so kann bei einer Verzögerungszeit oder Zeitspanne Δt von beispielsweise 10 Millisekunden der Schwellenwert 26 von dem Ausgangswert 5 N auf einen geänderten Wert von 4 N verringert werden. Dann bewirkt also bereits das Überschreiten des Schwellenwerts der Kraft F von 4 N das Ansteuern des Aktors 28, und nach dem Verstreichen der Zeitspanne Δt erzeugt der Aktor 28 die haptische Rückmeldung. Dies führt dazu, dass der Benutzer die haptische Rückmeldung dann wahrnimmt, wenn die tatsächlich von dem Benutzer aufgebrachte Kraft F 5 N beträgt und somit oberhalb des verringerten Schwellenwerts 26 von 4 N liegt.

Die vom Benutzer gefühlte Auslösekraft ist daher bei der in Fig. 1 gezeigten Bedienvorrichtung 10 nahezu unabhängig von der Betätigungsgeschwindigkeit beziehungsweise vom Gradienten 32 der Kraft F. Durch die Berücksichtigung des Kraftgradienten kann also bei aktorischen Bedienvorrichtungen 10 oder Bedienelementen eine Latenzkompensation, also eine Kompensation der Verzögerungszeit oder Zeitspanne Δt, erreicht werden.

## Patentansprüche

1. Bedienvorrichtung (10) zum Ansteuern von Funktionseinheiten eines Kraftfahrzeugs, mit einer berührungsempfindlichen Oberfläche (14), mit Mitteln (16) zum Erfassen einer Kraft (F), welche von einem Benutzer auf wenigstens einen Bereich der berührungsempfindlichen Oberfläche (14) aufbringbar ist, und mit einem Aktor (28) zum Erzeugen einer haptischen Rückmeldung an den Benutzer in Abhängigkeit vom Überschreiten eines Schwellenwerts (26) der Kraft (F),
wobei eine Auswerteeinrichtung (30) der Bedienvorrichtung (10) dazu ausgebildet ist, einen auf die Zeit (t) bezogenen Gradienten (32) der Kraft (F) zu ermitteln, und dazu, den Schwellenwert (26) der Kraft (F) in Abhängigkeit von dem ermittelten Gradienten (32) zu verringern, die Bedienvorrichtung (10) **dadurch gekennzeichnet, dass** die Auswerteeinrichtung (30) dazu ausgebildet ist, den Schwellenwert der Kraft (F) auf 70 % bis 90 % eines Ausgangswerts der Kraft (F) zu verringern, wenn ein Wert des Gradienten (32) größer ist als ein vorbestimmter Wert.

2. Bedienvorrichtung nach Anspruch 1,
**dadurch gekennzeichnet, dass**
die Auswerteeinrichtung (30) dazu ausgebildet ist, beim Verändern des Schwellenwerts der Kraft (F) die Länge einer Zeitspanne (Δt) zu berücksichtigen, um welche das Erzeugen der haptischen Rückmeldung gegenüber dem Überschreiten des Schwellenwerts (26) der Kraft (F) verzögert ist.

3. Bedienvorrichtung nach Anspruch 2,
**dadurch gekennzeichnet, dass**
die Auswerteeinrichtung (30) dazu ausgebildet ist, den Schwellenwert (26) der Kraft (F) um so stärker zu verändern, je größer die Länge der Zeitspanne (Δt) ist.

4. Bedienvorrichtung nach Anspruch 2 oder 3,
**dadurch gekennzeichnet, dass**
die Bedienvorrichtung (10) Mittel zum Erfassen der Länge der Zeitspanne (Δt) aufweist.

5. Bedienvorrichtung nach einem der Ansprüche 1 bis 4,
**dadurch gekennzeichnet, dass**
die Bedienvorrichtung (10) als Touchpad oder als Touchscreen ausgebildet ist.

6. Kraftfahrzeug mit wenigstens einer Bedienvorrichtung (10) nach einem der Ansprüche 1 bis 5.

7. Verfahren zum Ansteuern von Funktionseinheiten eines Kraftfahrzeugs, bei welchem eine Kraft (F) erfasst wird, welche von einem Benutzer auf wenigstens einen Bereich einer berührungsempfindlichen Oberfläche (14) einer Bedienvorrichtung (10) aufgebracht wird, bei welchem mittels eines Aktors (28) in Abhängigkeit vom Überschreiten eines Schwellenwerts (26) der Kraft (F) eine haptische Rückmeldung an den Benutzer erzeugt wird, und bei welchem wenigstens eine der Funktionseinheiten angesteuert wird,
das Verfahren **dadurch gekennzeichnet, dass** mittels einer Auswerteeinrichtung (30) der Bedienvorrichtung (10) ein auf die Zeit (t) bezogener Gradient (32) der Kraft (F) ermittelt wird, wobei der Schwellenwert (26) der Kraft (F) in Abhängigkeit von dem ermittelten Gradienten (32) verändert wird, wobei der Schwellenwert der Kraft (F) auf 70 % bis 90 % eines Ausgangswerts der Kraft (F) verringert wird, wenn ein Wert des Gradienten (32) größer ist als ein vorbestimmter Wert.

## Claims

1. Operating device (10) for actuating functional units of a motor vehicle with a touch-sensitive surface (14), with means (16) for detecting a force (F), which can be applied by a user to at least one area of the touch-sensitive surface (14), and with an actuator (28) for generating haptic feedback to the user in response to the exceeding of a threshold value (26) of the force (F),
wherein an evaluation unit (30) of the operating device (10) is configured to calculate a time-related (t) gradient (32) of the force (F), and to reduce the threshold value (26) of the force (F) as a function of the calculated gradient (32),
the operating device (10) **characterised in that** the evaluation unit (30) is configured to reduce the threshold value of the force (F) to 70% to 90% of an initial value of the force (F), when a value of the gradient (32) is greater than a predetermined value.

2. Operating device according to claim 1,
**characterised in that**
the evaluation unit (30) is configured to take account, when the threshold value of the force (F) changes, of the length of a time period (Δt) between the generation of the haptic feedback and the exceeding of the threshold value (26) of the force (F).

3. Operating device according to claim 2,
**characterised in that**
the evaluation unit (30) is configured to change the threshold value (26) of the force (F) as the time period (Δt) increases.

4. Operating device according to claim 2 or 3,
**characterised in that**
the operating device (10) has means for detecting the length of the time period (Δt).

5. Operating device according to any one of claims 1 to 4,
**characterised in that**
the operating device (10) is configured as a touchpad or touch screen.

6. Motor vehicle with at least one operating device (10) according to any one of claims 1 to 5.

7. Method for actuating functional units of a motor vehicle, which comprises detecting a force (F) applied by a user to at least one area of a touch-sensitive surface (14) of an operating device (10), generating haptic feedback to the user by means of an actuator (28) in response to the exceeding of a threshold value (26) of the force (F), and actuating at least one of the functional units,
the method **characterised in that**
a time-related (t) gradient (32) of the force (F) is detected by means of an evaluation unit (30) of the operating device (10), wherein the threshold value (26) of the force (F) is changed as a function of the calculated gradient (32), wherein the threshold value of the force (F) is reduced to 70% to 90% of an initial value of the force (F) when a value of the gradient (32) is greater than a predetermined value.

## Revendications

1. Dispositif de commande (10) pour commander des unités fonctionnelles d'un véhicule automobile, comprenant une surface sensible au contact (14), des moyens (16) pour détecter une force (F) qui peut être appliquée par un utilisateur à au moins une zone de la surface sensible au contact (14) et un actionneur (28) pour produire un rétrosignal haptique sur l'utilisateur en fonction du dépassement d'une valeur de seuil (26) de la force (F),
dans lequel un dispositif d'évaluation (30) du dispositif de commande (10) est formé de manière à déterminer un gradient (32) de la force (F) par rapport au temps (t) et à réduire la valeur de seuil (26) de la force (F) en fonction du gradient déterminé (32),
le dispositif de commande (10) étant **caractérisé en ce que** le dispositif d'évaluation (30) est formé de manière à réduire la valeur de seuil de la force (F) à 70 % à 90 % d'une valeur initiale de la force (F) lorsqu'une valeur du gradient (32) est supérieure à une valeur prédéterminée.

2. Dispositif de commandé selon la revendication 1,
**caractérisé en ce que**
le dispositif d'évaluation (30) est formé de manière à, lors de la modification de la valeur de seuil de la force (F), tenir compte de la longueur d'un intervalle de temps (Δt) dont le rétrosignal haptique est différé vis-à-vis du dépassement de la valeur de seuil (26) de la force (F).

3. Dispositif de commande selon la revendication 2,
**caractérisé en ce que**
le dispositif d'évaluation (30) est formé de manière à modifier la valeur de seuil (26) de la force (F) assez fortement pour que la longueur de l'intervalle de temps (Δt) soit plus grande.

4. Dispositif de commande selon la revendication 2 ou 3,
**caractérisé en ce que**
le dispositif de commande (10) présente des moyens pour détecter la longueur de l'intervalle de temps (Δt).

5. Dispositif de commande selon l'une quelconque des revendications 1 à 4,
**caractérisé en ce que**
le dispositif de commande (10) se présente sous la forme d'un bloc à effleurement ou d'un écran tactile.

6. Véhicule automobile comportant au moins un dispositif de commande (10) selon l'une quelconque des revendications 1 à 5.

7. Procédé de commande d'unités fonctionnelles d'un véhicule automobile, dans lequel est détectée une forcé (F) qui est appliquée par un utilisateur sur au moins une zone d'une surface sensible au contact (14) d'un dispositif de commande (10), dans lequel, en fonction du dépassement d'une valeur de seuil (26) de la force (F), un rétrosignal haptique est produit au moyen d'un actionneur (28) sur l'utilisateur et dans lequel au moins l'une des unités fonctionnelles est commandée,
le procédé étant **caractérisé en ce que**, au moyen d'un dispositif d'évaluation (30) du dispositif de commande (10), on détermine un gradient (32) de la force (F) par rapport au temps (t), dans lequel la valeur de seuil (26) de la force (F) est modifiée en fonction du gradient déterminé (32), dans lequel la valeur de seuil de la force (F) est réduite à 70 % à 90 % d'une valeur initiale de la force (F) lorsqu'une valeur du gradient (32) est plus grande qu'une valeur prédéterminée.
